Europäisches Patentamt

European Patent Office

Office européen des brevets

(11) Veröffentlichungsnummer: **0 098 318**
**B1**

(12) EUROPÄISCHE PATENTSCHRIFT

(45) Veröffentlichungstag der Patentschrift: **11.02.87**

(21) Anmeldenummer: **82105957.3**

(22) Anmeldetag: **03.07.82**

(51) Int. Cl.⁴: **H 01 L 21/308,**
H 01 L 21/306, G 03 F 1/00,
G 03 F 7/02

(54) **Verfahren zum Herstellen von Gräben mit im wesentlichen vertikalen Seitenwänden in Silicium durch reaktives Ionenätzen.**

(43) Veröffentlichungstag der Anmeldung:
**18.01.84 Patentblatt 84/03**

(45) Bekanntmachung des Hinweises auf die Patenterteilung:
**11.02.87 Patentblatt 87/07**

(84) Benannte Vertragsstaaten:
**DE FR GB IT**

(56) Entgegenhaltungen:
EP-A-0 012 859
EP-A-0 048 291
WO-A-80/00639

IEEE TRANSACTIONS ON ELECTRON DEVICES. Band ED-28, Nr. 11, November 1981, Seiten 1405-1410, New York, USA M. O'TOOLE et al.: "Linewidth control in projection lithography using a multilayer resist process"

JOURNAL OF THE ELECTROCHEMICAL SOCIETY, Band 126, Nr. 6, Juni 1979, Seiten 1024-1028, Princeton, USA K. SUZUKI et al.: "The roles of ions and neutral active species in microwave plasma etching"

(73) Patentinhaber: **IBM DEUTSCHLAND GMBH**
**Pascalstrasse 100**
**D-7000 Stuttgart 80 (DE)**

(73) Patentinhaber: **International Business Machines Corporation**
**Old Orchard Road**
**Armonk, N.Y. 10504 (US)**

(72) Erfinder: **Behringer, Uwe, Dr. Dipl.-Phys.**
**Wolfsbergstrasse 27**
**D-7403 Ammerbuch (DE)**
Erfinder: **Greschner, Johann, Dr.**
**Zollernstrasse 14**
**D-7401 Pliezhausen (DE)**
Erfinder: **Trumpp, Hans-Joachim, Dr.**
**Pfeilstrasse 26**
**D-7000 Stuttgart 80 (DE)**

(74) Vertreter: **Kreidler, Eva-Maria, Dr. rer. nat.**
**Schönaicher Strasse 220**
**D-7030 Böblingen (DE)**

(56) Entgegenhaltungen
EXTENDED ABSTRACTS, Band 79-2, 14.-19. Oktober 1979, Seiten 1521-1523, Princeton, N.J., USA J.L. MAUER et al.: "The effects of pressure in reactive ion etching"

Courier Press, Leamington Spa, England.

**Beschreibung**

Die Erfindung betrifft ein Verfahren zum Herstellen von Gräben mit im wesentlichen vertikalen Seitenwänden in Silicium durch reaktives Ionenätzen und unter Verwendung einer Photoresistmaske, die in einem Dreilagenprozeß hergestellt wird.

Es ist heute üblich, Muster mit Linienbreiten und Abständen in der Größenordnung von einem μm oder darunter mit Elektronenstrahlen, Röntgenstrahlen oder mittels optischer Lithographie aufzuzeichnen. Die meisten dieser Muster werden in einem strahlungsempfindlichen Photoresist und nicht direkt in oder auf dem gewünschten Substrat aufgezeichnet. Die Übertragung der feinen Muster auf das Substrat erfolgt dann in einem weiteren Schritt entweder durch Ätzen oder nach einem Verfahren, in dem Abscheidung und Lift-off-Technik kombiniert sind. Während die Aufzeichnung des Musters in den Photoresist mit sehr hoher Auflösung und Genauigkeit erfolgen kann, ist es sehr viel schwieriger und in vielen Fällen unmöglich, eine vergleichbare Liniendefinition nach der Übertragung des Musters zu erhalten. Die miesten der üblicherweise verwendeten Übertragungsverfahren unterliegen Beschränkungen, die besonders dann ins Gewicht fallen, wenn Muster mit Tiefen im Bereich einiger μm übertragen werden sollen, die heute beispielsweise bei der Herstellung von Siliciumgräben für die eingesenkte Oxidisolation oder von Elektronenstrahl-Transmissionsmasken benötigt werden.

Für die Übertragung der Photoresistmuster in das Substrat werden im allgemeinen Trockenätzverfahren angewendet. Die Übertragung eines Musters in ein Siliciumhalbleitersubstrat kann beispielsweise durch Kathodenzerstäubungsätzen, durch Plasmaätzen oder durch reaktives Ionenätzen vorgenommen werden, wobei letzteres wegen seines hohen Grades an gerichtetem Ätzen besonders vorteilhaft ist.

Aus der deutschen Auslegeschrift DE—B—26 17 483 ist ein Verfahren zum selektiven Abtragen von Metall und/oder Halbleitermaterialien mittels reaktiver Ionenätzung bekannt, bei dem die zu behandelnden Substrate unter Verwendung einer Maske aus Photolack oder aus dielektrischen Materialien wie $SiO_2$, $Si_3N_4$ oder $Al_2O_3$ einem hochfrequent angeregten Plasma in einer Atmosphäre unter Vorvakuumbedingungen ausgesetzt werden. Die Atmosphäre besteht aus einem Inertgas wie Argon oder Helium und einem dissoziierbaren Gas aus der Gruppe von $CCl_4$, $Cl_2$, $Br_2$, $I_2$ und HCl. Die in dem entsprechenden Plasma enthaltenen Atome, Ionen oder Radikale befinden sich in einem hochreaktiven Zustand, so daß sie mit den freigelegten Oberflächenbereichen beispielsweise eines Siliciumhalbleitersubstrats chemisch reagieren können unter Ausbildung flüchtiger Reaktionsprodukte wie Siliciumchlorid, Bromid oder Jodid. Bei diesem Verfahren lassen sich Ätzraten erzielen, die weit über denen eines üblichen Kathodenzerstäubungsverfahrens liegen, bei dem die Atmosphäre lediglich ein Inertgas enthält. Gegenüber dem Plasmaätzverfahren zeichnet sich dieses Verfahren durch seinen hohen Grad an gerichtetem (anisotropem) Ätzen aus, wodurch nahezu vertikale Seitenwände in dem geätzten Halbleitermaterial erhalten werden.

Das selektive Ätzen son Silicium in einem Hochfrequenzinduzierten Plasma, welches Chlor und Argon enthält und in dem der Chloranteil etwa 3% beträgt, ist auch in den Europäischen Patentanmeldungen EP—A—0 000 897 (78 100 614.3) und EP—A—0 001 100 (78 100 804.0) beschrieben. Nachteilig an dem System Chlor/Argon sind aber seine hohe Giftigkeit und Korrosionskraft, wodurch besondere und äußerst kostspielige Sicherheitsvorkehrungen während des Ätzens erforderlich sind. Nachteilig ist auch, daß zusätzliche Prozeßschritte zur Herstellung einer Ätzmaske aus $SiO_2$ erforderlich sind, weil Photoresist-Ätzmasken diesen aggressiven Gasen nicht standhalten.

Aus der Europäischen Patentanmeldung EP—A—0 015 403 (80 100 648.7) ist ein Verfahren zum Ätzen von Silicium zur Herstellung von eingelegten Isolationsbereichen bekannt, bei dem die zu ätzenden Siliciumbereiche mit einem Plasma in Berührung gebracht werden, bei dessen Erzeugung von einer Gasmischung ausgegangen wird, welche ungefähr 10 Vol.% $SF_6$ und $Cl_2$ und als Rest Helium enthält. Dieses Gasgemisch ist selektiv, d.h. unter den angegebenen Bedingungen wird 100-orientiertes Silicium etwa 24 mal schneller geätzt als Siliciumnitrid, welches als Maskenmaterial verwendet wird. Von Vorteil ist auch, daß das Ätzen gerichtet ist, daß praktisch kein seitliches Ätzen stattfindet und dadurch streng vertikale Seitenwände erhalten werden. Diesen Vorteilen stehen die Nachteile der hohen Giftigkeit und Aggressivität des Systems gegenüber, die, wie bereits bei dem System Chlor/Argon angegeben, umfangreiche Sicherheitsvorkehrungen und zusätzliche Prozeßschritte für die Herstellung der Maske erforderlich machen. Ähnliches gilt auch für Systeme wie $CCl_2F_2/O_2$ und $SiF_4/Cl_2$/Helium oder Argon (EP—A—0 036 144, 81 101 630.2).

Es gibt umfangreiche Literatur, in der das Ätzen von Halbleitermaterialien in Kohlenstofftetrafluoridplasmen beschrieben ist. $CF_4$ in Mischung mit Wasserstoff oder Sauerstoff ist als Ätzgas in der Halbleitertechnologie eingeführt. Es ist ungiftig und benötigt keine speziellen Sicherheitsvorkehrungen wie separat abgepumptes Gaskabinett und dgl. Bisher wurde festgestellt, daß $CF_4$ wegen des hohen Fluoranteils in Plasma Silicium vorwiegend isotrop ätzt, das heißt, es findet eine seitliche Unterätzung des Siliciums auch bei Verwendung einer idealen Maske statt. Eine Maske ist ideal, wenn ihre Ätzrate vernachlässigbar gering ist (z. B. eine MgO-Maske). Außerdem stellte J. A. Bondur in J. Vac. Sci. Technol. *13*, 1023 (1976) fest, daß immer dann, wenn Silicium in $CF_4$ geätzt wird, ein laterales Ätzen der Resistmaskenmuster beobachtet wird, was ebenfalls zu nichtvertikalen Wänden der geätzten Profile führt.

Es war bekannt, daß CF$_4$ das Photoresist-material, aus welchem die Maske besteht, ätzt und zwar im allgemeinen genauso schnell oder sogar noch schneller als das Material, das eigentlich geätzt werden soll. Deshalb sind dicke Maskierungsschichten erforderlich, bei deren Bearbeitung es schwierig ist, festgelegte Linienbreiten mit der notwendigen Genauigkeit einzuhalten. Es ist bekannt, daß sich Variationen in der Resistschichtdicke nicht nur negativ auf die Einhaltung festgelegter Linienbreiten in den Resistbildern auswirken, sondern auch bei der Übertragung von Mustern durch Plasma- oder reaktives Ionenätzen eine Rolle spielen. In bestimmten Fällen kann eine nicht ausreichende Resistschichtdicke in bestimmten Bereichen dazu führen, daß diese dem Plasma- oder reaktiven Ionenätzen nicht standhalten. Also eine mögliche Lösung dieser Probleme schlägt N. H. Bowden in "Forefront of Research on Resists", Solid State Technology, Juni 1981, S. 74, 75 vor, eine dicke, beispielsweise eine 2,6 µm dicke Schicht aus organischem Material, welche sich der Topologie des Wafers anpaßt, auf den Wafer aufzutragen. Die Strukturierung dieser dicken ebenen Schicht erfolgt über eine auf derselben abgeschiedene, intermediäre Maskenschicht aus SiO$_2$ (Schichtdicke 0,1 µm), in der das gewünschte Muster unter Verwendung einer durch übliche Photolithographie erzeugten Resistmaske durch reaktives Ionenätzen erzeugt wird. Die dünne, oberste Resistschicht kann aus einem hochempfindlichen Resist bestehen, für den eine Bedingung ist, daß er das reaktive Ionenätzen der 0,1 µm dicken SiO$_2$-Schicht übersteht. Nachdem das Muster in der obersten Resistschicht durch Belichten und Entwickeln hergestellt ist, wird die dünne SiO$_2$-Schicht mit CHF$_3$-Gas durch Plasmaätzen oder reaktives Ionenätzen strukturiert. Das Muster wird dann in die dicke organische Schicht übertragen durch reaktives Ionenätzen in einem Sauerstoffplasma unter Verwendung der SiO$_2$-Maske. Auf diese Weise kann in der dicken organischen Schicht ein Muster mit Submikrometerauflösung und nahezu vertikalen Seitenwänden hergestellt werden; und zwar unabhängig von der Wafertopologie. Die so hergestellte dicke Maske aus organischem Material kann beispielsweise zur Strukturierung des darunterliegenden Substrats oder als Implantationsmaske verwendet werden. Der zuvor beschriebene Dreilagenprozeß ist auch in der PCT Anmeldung WO—A—80/00639, US Priorität 11. November 1978 (Aktenz. 941 369) beschrieben.

In IEEE Transactions on Electron Devices, Vol. ED—28 (1981) No. 11, November, S. 1405—1410, ist ein Dreilagenresistprozeß beschrieben, bei dem auf ein zu planarisierendes Substrat eine 1 bis 3 µm dicke Schicht aus einem absorbierenden Polymer aufgetragen wird. Auf dieser wird in einem speziellen Ausführungsbeispiel eine 130 nm dicke Zwischenschicht aus Siliciumnitrid abgeschieden u. als oberste Schicht eine etwa 0,5 µm dicke Photoresistschicht aufgetragen. Die Musterübertragung von der obersten Resistschicht in das Siliciumnitrid erfolgt durch Plasmaätzen mit CF$_4$ bei einem Druck von 5,3 µbar und die Übertragung zur untersten Polymerschicht durch reaktives Ionenätzen in O$_2$-Atmosphäre bei einem Druck von 5,3 µbar.

In der Europäischen Patentanmeldung EP—A—0 048 291 ist eine Maskenstruktur für die Röntgenstrahllithographie und ein Verfahren zur Herstellung derselben beschrieben. Diese Maskenstruktur, welche aus einem Siliciumkörper mit mindestens einer durchgehenden Öffnung besteht, ist mindestens teilweise mit einer dünnen Metallsilizidschicht bedeckt.

Ausgehend von diesem Stand der Technik ist die Aufgabe der Erfindung, ein Verfahren zum Herstellen von Gräben in Silicium mit im wesentlichen vertikalen Seitenwänden durch reaktives Ionenätzen anzugeben, bei dem das völlig ungiftige CF$_4$ zum gerichteten Ätzen verwendet werden kann. Die für diesen Prozeß erforderliche dicke Photoresistmaske wird in einem Dreilagenprozeß hergestellt.

Die Aufgabe der Erfindung wird gelöst durch ein Verfahren der eingangs genannten Art, dessen Merkmale im Patentanspruch 1 niedergelegt sind.

Vorteilhafte Ausgestaltungen der Erfindung sind in den Unteransprüchen niedergelegt.

Die Erfindung wird anhand der speziellen Beschreibung und der Abbildungen näher beschrieben.

Es zeigen:

Fign. 1A bis 1E Querschnittsdarstellungen eines Verfahrens zur Herstellung eines tiefen Grabens in einem Siliciumsubstrat;

Fig. 2A bis 2E Darstellungen eines Verfahrens zur Herstellung einer Maske;

Fig. 3 eine SEM-Aufnahme eines 3 µm tiefen Grabens in Silicium, der mit CF$_4$ anisotrop geätzt wurde.

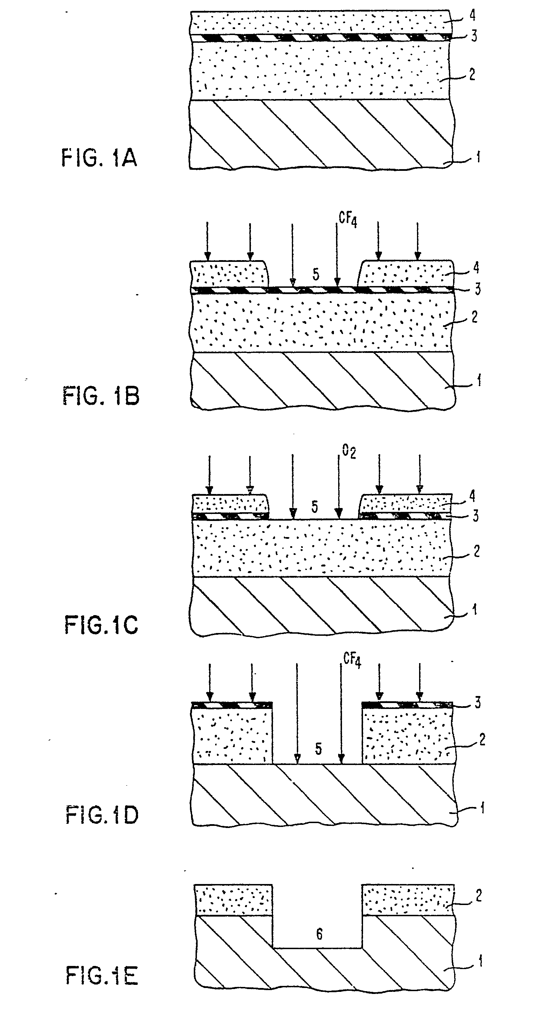

In den Fign. 1A bis E, anhand derer ein Verfahren zur Herstellung eines tiefen Grabens 6 in einem Siliciumsubstrat gezeigt wird, ist jeweils ein Ausschnitt aus einer Halbleiteranordnung gezeigt, in dem mit 1 ein Halbleitersubstrat, beispielsweise aus 100-orientiertem Silicium bezeichnet wird. Die Oberfläche des Substrats 1 kann eben sein, es kann aber auch eine Oberflächentopologie aufweisen. Auf die Oberfläche des Substrats 1 wird eine verhältnismäßig dicke Schicht 2 aus organischen Materialien, die sich leicht durch Aufschleudern oder Aufsprühen auftragen lassen und eine gute Adhäsion zur Oberfläche des Substrats 1 aufweisen, aufgetragen. Es ist von Vorteil, wenn die Schicht 2 einen Brechungsindex aufweist, der den Brechungsindices der nachfolgend aufgetragenen Schichten 3 und 4 entspricht. Für die Anwendung in der Elektronenstrahl- oder Röntgenstrahllithographie ist es auch günstig, wenn die Schichten 3 und 4 aus Materialien bestehen, die Elektronen geringfügig streuen.

Es gibt zahlreiche Verbindungen organischer Materialien, aus denen die Schicht 2 hergestellt werden kann. Als solche kommen eine Vielzahl bekannter positiver und negativer Photoresistmaterialien, beispielsweise die üblichen Phenol-Formaldehyd-Novolakharze, Polymethylmethacrylate, Polyisoprene oder Materialien, die in den US—Patentschriften US—A—3 201 239 und US—A—3 770 433 beschrieben sind, in Frage. Es können auch Polymermaterialien, die keine Photoleiter sind, zur Ausbildung der Schicht 2 verwendet werden. Da das zum Ätzen des Siliciumsubstrats 1 verwendete $CF_4$ die Schicht 2 aus organischem Material im allgemeinen schneller ätzt als das Silicium 1, wird eine verhältnismäßig dicke Schicht 2 aus organischem Material benötigt. Sie sollte vorzugsweise etwa doppelt so dick sein wie die gewünschte Grabentiefe im Silicium. In einem bevorzugten Ausführungsbeispiel wurde als Schicht 2 ein Positivphotoresist AZ 1350J der Firma Shipley, welcher aus einem Phenol-Formaldehyd-Harz und 3,4-Dihydroxybenzophenon - 4 - [naphthochinon(1,2)diazid(2)] - sulfonat als reaktivem Bestandteil besteht, in einer Schichtdicke von etwa 6 µm aufgetragen.

Die Schicht 2 kann auch Schichtdicken von etwa 9 µm aufweisen. Die Schicht 2 wurde bei 210°C etwa 30 Minuten lang gehärtet. Auf die dicke Resistschicht 2 wird eine Siliciumnitridschicht 3 in einer Schichtdicke von 0,1 bis 0,2 µm durch Plasmaabscheidung aufgetragen. Die Siliciumnitridschicht 3 stellt eine besonders vorteilhafte Maske für das reaktive Ionenätzen der Photoresistschicht 2 mit Sauerstoff dar und dient gleichzeitig zur Verbesserung der Adhäsion der obersten dünnen Resistschicht 4 auf der Unterlage. Es hat sich gezeigt, daß das Siliciumnitrid, das anstelle des hierfür bekannten Siliciumdioxids verwendet wird, besondere Vorteile aufweist. So ist beispielsweise eine 0,1 µm dicke Siliciumnitridschicht 3 gegenüber dem reaktiven Ionenätzen einer etwa 9 µm dicken 1350J-Photoresistschicht 2 beständig. Außerdem läßt sich die Nitridschicht etwa zweimal schneller ätzen als eine Siliciumdioxidschicht vergleichbarer Schichtdicke, was zu Vorteilen führt, auf die bei der nachfolgenden Beschreibung des reaktiven Ionenätzverfahrens noch näher eingegangen wird.

Auf die dünne Siliciumnitridschicht 3 wird eine hochempfindliche Photoresistschicht 4 in einer Dicke von etwa 0,2 bis 1 µm aufgetragen. Die einzige Forderung an diese oberste, hochempfindliche Photoresistschicht 4 ist, daß sie widerstandsfähig ist gegenüber dem reaktiven Ionenätzen der 0,1 bis 0,2 µm dicken Siliciumnitridschicht 3. In einem bevorzugten Ausführungsbeispiel besteht diese Photoresistschicht aus einem Elektronenstrahl-empfindlichen Resist, beispielsweise aus dem IBM High Contrast-Resist, welcher ein Resist auf der Basis eines Kresol-Formaldehydharzes mit einem Naphthochinondiazid-Sensibilisator ist. Ein anderer im Handel unter der Bezeichnung AZ 2400 von der Firma Shipley erhältlicher Resist auf der gleichen Grundlage oder Polymethylmethacrylat sind weitere geeignete Resistmaterialien.

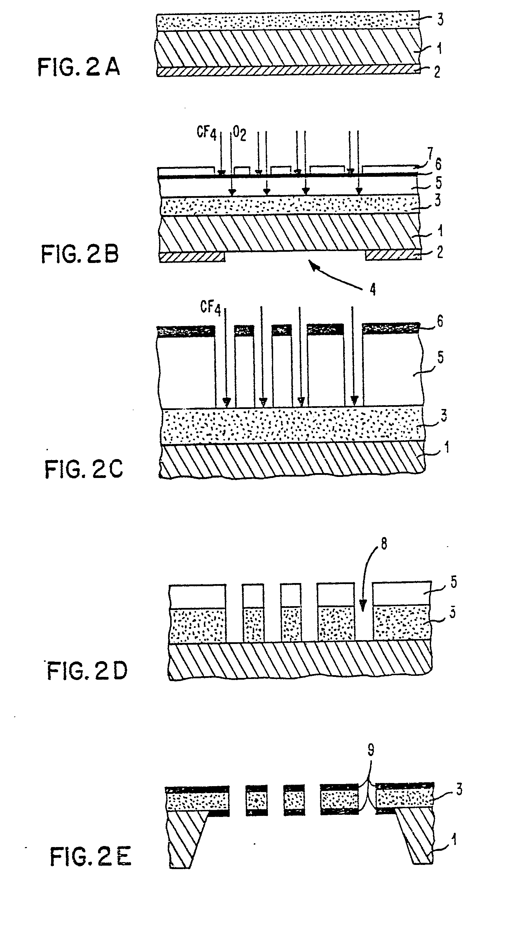

Anhand der Fign. 1B bis 1D wird das Verfahren zur Herstellung der dicken Photoresistmaske für das Ätzen des Grabens 6 in das Siliciumsubstrat 1 (Fig. 1E) näher beschrieben. Das gewünschte Muster 5 wird in der obersten Resistschicht 4 in bekannter Weise durch Belichten und Entwickeln hergestellt. Für Muster im Submikronbereich wird eine Elektronenstrahlbelichtung vorgenommen. Nach der Belichtung und Entwicklung zeigt die Schicht 4 eine etwas verminderte, einheitliche Schichtdicke. Anschließend wird unter Verwendung der Photoresistmaske 4 in der Siliciumnitridschicht 3 ein entsprechendes Muster hergestellt. Die Übertragung des Musters erfolgt durch reaktives Ionenätzen mit folgenden Parametern:

| | |
|---|---|
| Gas: | $CF_4$ |
| Fluß: | 30 cm³/Min. |
| Druck: | 66,5 µbar |
| Energiedichte: | 0,2 Watt/cm² |
| Ätzrate (Plasmanitrid): | 25—30 nm/Min. |

Alle Ätzraten im Rahmen der vorliegenden Erfindung stellen keine optimierten Ätzraten dar. Bei höherer Energiedichte können höhere Ätzraten erhalten werden.

Daz zuvor beschriebene reaktive Ionenätzen der Siliciumnitridschicht 3, wie auch das reaktive Ionenätzen der dicken Photoresistschicht 2 und des Grabens 6 in das Siliciumsubstrat 1, werden in der gleichen Reaktionskammer ausgeführt. Eine Vorrichtung, die zur Durchführung des erfindungsgemäßen Verfahrens geeignet ist, ist beispielsweise in der deutschen Auslegeschrift DE—B—26 17 483 beschrieben. Außer dem zuvor beschriebenen reaktiven Ionenätzverfahren könne auch andere Trockenätzverfahren, die ein kontrollierbares anisotropes Ätzen gestatten, zur Strukturierung der Schicht 3 verwendet werden. Wesentlich ist, daß mit diesen Verfahren nahezu vertikale Seitenwände erhalten werden können und keine seitliche Unterätzung der zu strukturierenden Schicht stattfindet. Das resultierende Muster in der Schicht 3 entspricht genau dem Muster in der obersten Photoresistschicht 4.

Die strukturierte Siliciumnitridschicht 3 dient als Maske in einem weiteren reaktiven Ionenätzverfahren, bei dem das der Maske entsprechende Muster mit Sauerstoff in die dicke Photoresistschicht 2 geätzt wird (Fign. 1C und D). Die Parameter für das Ätzen der AZ 1350J-Photoresistschicht mit Sauerstoff sind folgende:

| | |
|---|---|
| Gas: | $O_2$ |
| Fluß: | 27 cm³/Min. |
| Druck: | 2,6 µbar |
| Energiedichte: | 0,2 Watt/cm² |
| Ätzrate (AZ 1350J): | 500 nm/Min. |

Bei diesem Verfahrensschritt werden streng vertikale Photoresistprofile erhalten. Hervorzuheben ist, daß streng vertikale Photoresistwände in einem $O_2$-Plasma nur bei einem extrem niedrigen Sauerstoffdruck unterhalb von etwa 4 µbar erhalten werden können. Wird das reaktive Ionenätzen in Sauerstoff, aber bei einem Druck von beispielsweise 133 µbar durchgeführt, dann wird eine Öffnung 5 erhalten, die reproduzierbar lateral um etwa 200 bis 300 nm aufgeweitet ist. Nunmehr ist die Photoresistmaske, die zum Ätzen des Grabens 6 in das Siliciumsubstrat 1 benötigt wird, fertiggestellt. Wie aus Fig. 1D ersichtlich ist, weist die dicke Photoresistmaske nach dem Ätzen mit Sauerstoff streng vertikale Resistprofile auf.

Ein Vorteil des zuvor beschriebene Dreilagenprozesses ist, daß mit ihm eine dicke Resistmaske mit vertikalen Seitenwänden, die sich für das reaktive Ionenätzen von tiefen Gräben eignet, hergestellt werden kann. Ein weiterer Vorteil des Dreilagenprozesses liegt darin, daß der störende Schattenwurfeffekt in der Elektronenstrahllithographie, der auf eine Elektronenstreuung in dem Resist 2 und dem Substratmaterial 1 zurückzuführen ist und zu unterschiedlichen Dosen führt, weitgehend vermieden werden kann. Hervorzuheben ist, daß das Muster, das in der dicken Photoresistschicht 2 (Fig. 1D) hergestellt wurde, nahezu identisch mit dem hochaufgelösten Muster 5 ist, das ursprünglich in der dünnen Photoresistschicht 4 hergestellt wurde.

Im nächsten Schritt werden die Gräben 6 in das Siliciumsubstrat 2 geätzt. Vor der detaillierten Beschreibung der Durchführung dieses Verfahrens wird noch auf die Mechanismen, die beim reaktiven Ionenätzen von Silicium mit $CF_4$ eine Rolle spielen, eingegangen.

Normalerweise müßte es mit einem kathodengekoppelten System, wie es in der vorliegenden Erfindung angewendet wird und bei dem eine gerichtete Beaufschlagung mit Ionen stattfindet, möglich sein, in das Silicium Gräben mit streng vertikalen Seitenwänden, die die Maske wiedergeben, zu ätzen. In der Praxis findet jedoch im $CF_4$-Plasma ein laterales Ätzen des Resistmaskenmusters statt und Muster mit vertikalen Seitenwänden werden selten erhalten. Selbst wenn eine Photoresistmaske wie die nach dem zuvor beschriebenen Dreilagenprozeß hergestellte vertikale Seitenwände aufweist, ist noch nicht gewährleistet, daß auch im Silicium Gräben mit vertikalen Seitenwänden erhalten werden. Die Form oder die Böschungswinkel der geätzten Gräben werden nämlich durch mehrere Parameter bestimmt. Als Maß für die Dimension der geätzten Struktur dient der sogenannte "Ätzbias". Hierunter wird die Dimensionsänderung, die während des Ätzens stattfindet, verstanden. Die Dimensionsänderung ist definiert als das Verhältnis der Breite des Photoresistbildes vor dem Ätzen zur Breite des geätzten Grabens, gemessen am Boden und nach dem Ätzen. Ziel der vorliegenden Erfindung ist, wie eingangs angegeben, Gräben in Silicium mit möglichst vertikalen Seitenwänden zu ätzen, also Strukturen, die praktisch keinen "Ätzbias" aufweisen.

Wie mehrfach beschrieben, ist es mit dem Dreilagenprozeß möglich, eine dicke Photoresistmaske mit vertikalen Seitenwänden herzustellen, so daß selbst bei einer Selektivität von $CF_4$ von etwa 1 für Silicium zu Photoresist das reaktive Ionenätzen von Silicium mit CF4 unter Verwendung einer Photoresistmaske möglich sein sollte, wenn die Dicke der Photoresistmaske entsprechend gewählt wird. Seither wurden jedoch beim Ätzen von Silicium mit $CF_4$ im Silicium nur Gräben mit Böschungswinkeln um 80° und mit Einkerbungen an den Kanten der Gräben erhalten, so daß der Fachmann abgehalten wurde, das ungiftige und völlig problemlos zu handhabende $CF_4$, das in der Halbleitertechnologie eingeführt ist, zum gerichteten Ätzen von Silicium zu verwenden.

Der hohe isotrope Anteil beim reaktiven Ionenätzen mit $CF_4$, durch den die zuvor angegebenen Böschungswinkel bedingt sind, läßt sich folgendermaßen erklären: Wenn die Oberfläche von 100-orientiertem Silicium einem fluorhaltigen Plasma ausgesetzt wird, wird an der Oberfläche während des Ätzens flüchtiges $SiF_2$ gebildet. Da im Siliciumkristallgitter nur etwa 46% des Raums, der durch feste Bausteine ausgefüllt werden kann, besetzt ist, sind im Kristallgitter Kanäle vorhanden, in die die kleinen Fluoratome aus dem Plasma leicht eindringen und Si-Si-Bindungen aufbrechen können. Das Eindringpotential beträgt ungefähr 1 eV und ist im Plasma verfügbar. Durch das Aufbrechen von zwei Si-Bindungen wird ein flüchtiges $SiF_4$-Molekül gebildet, welches abgepumpt wird. Dieser Vorgang ist isotrop und bewirkt eine seitliche Unterätzung des Siliciums bezüglich der Photoresistmaske in der gleichen Weise wie ein Naßätzverfahren. Der laterale Anteil beim Ätzen ist hoch.

Die Erfinder haben nun gefunden, daß ein gerichtetes (anisotropes) Ätzen von Silicium, welches durch $CF_3$+− Ionen bewirkt wird, durch eine Herabsetzung der Fluorkonzentration in Plasma begüngstigt werden kann. Im erfindungsgemäßen Verfahren wird diese herabgesetzt, durch die Wahl eines sehr niedrigen Flusses für $CF_4$, der kleiner oder gleich 10 cm³/Min. gewählt wird. Des weiteren kann die Fluorkonzentration durch eine fluorverbrauchende Kathode erniedrigt werden. Dies wird dadurch bewerkstelligt, daß in dem Reaktor, der zum Ätzen verwendet wird und der beispielsweise in der deutschen Auslegeschrift DE—B—26 17 483 beschrieben ist, die Siliciumwafer auf einer Platte aus Silicium liegen, die dann ihrerseits auf der Kathode aufliegt. Auf diese Weise ist es möglich, die Fluorkonzentration im Plasma so zu erniedrigen, daß ein Anisotropiefaktor von 20 bis 30 erreicht wird, d.h., die vertikale Ätzrate ist etwa 20 bis 30 mal höher als die laterale, so daß letztere vernachlässigt werden kann, oder mit anderen Worten, es ist praktisch kein "Ätzbias" vorhanden.

In Fig. 1E ist ein in das Siliciumsubstrat mit $CF_4$ geätzter Graben gezeigt. Es wurde mit folgenden Parametern gearbeitet:

| Gas: | $CF_4$ |
|---|---|
| Fluß | 10 cm³/Min. |
| Druck: | 39,9 µbar |
| Energiedichte: | 0,2 Watt/cm² |
| Ätzrate (Si): | 10—12 nm/Min. |

Selektivität gegen 1350J-Photoresist ≈ 1.

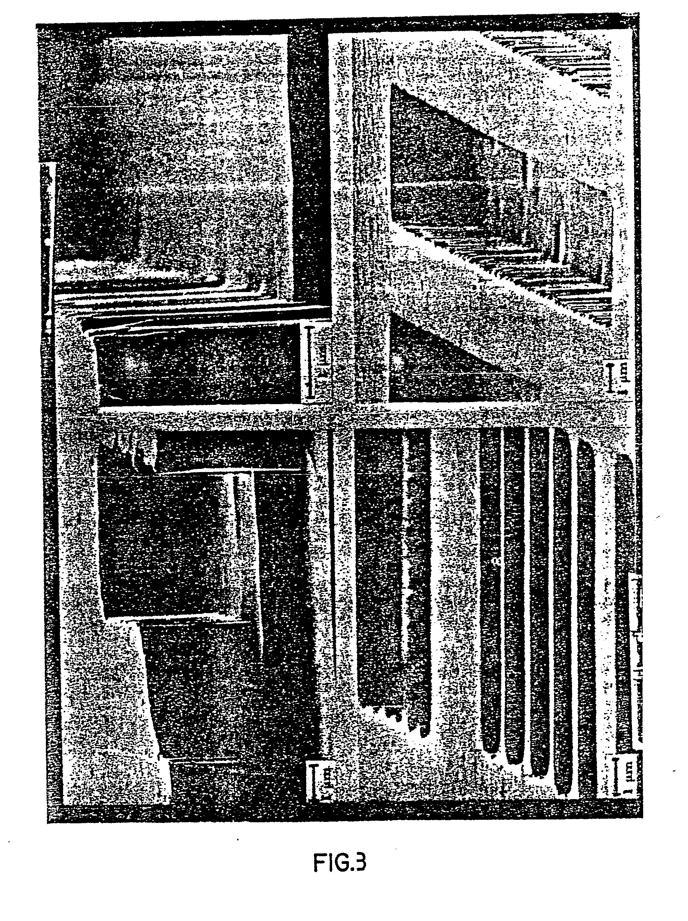

In Fig. 3 ist eine Rasterelektronenmikroskopaufnahme (SEM) eines 3 um tiefen Grabens in Silicium, der mit $CF_4$ unter den zuvor angegebenen Bedingungen geätzt wurde, gezeigt. Deutlich erkennbar sind die praktisch vertikalen Seitenwände der geätzten Strukturen.

Mit dem Verfahren zum Ätzen von Silicium, das zuvor anhand der Fign. 1A bis 1E beschrieben wurde, ist die Herstellung von tiefen Gräben mit praktisch vertikalen Seitenwänden möglich. Die hierzu erforderliche dicke Photoresistmaske mit vertikalen Seitenwänden der in das Siliciumsubstrat zu übertragenden Muster wird in einem Dreilagenprozeß hergestellt. Der an sich bekannte Dreilagenprozeß wird modifiziert, indem an Stelle von Siliciumdioxid Siliciumnitrid durch Plasmaabscheidung als Schicht 3 aufgetragen wird. Dieses Material ist äußerst vorteilhaft, weil es sich etwa 2 mal schneller ätzen läßt als Siliciumdioxid, wodurch ein noch geringerer "Ätzbias" erhalten wird. Bei der Übertragung des Musters 5 in der Photoresistschicht 4 (Fig. 1B) in das darunterliegende Siliciumnitrid 3 findet ein laterales Ätzen von nur etwa 50 nm statt. Beim Ätzen der Photoresistschicht 2 durch die Siliciumnitridmaske 3 (Fig. 1C) mit Sauerstoff findet kein laterales Ätzen statt, wenn darauf geachtet wird, daß der Sauerstoffdruck unter etwa 4 µbar liegt. Normalerweise ist bei diesen niedrigen Drucken der Kathodenzerstäubungseffekt wegen der größeren mittleren freien Weglänge des Sauerstoffs groß. So wurde festgestellt, daß Silicium und auch Siliciumdioxid unter diesen Bedingungen Abgetragen werden, so daß Siliciumdioxid als Material für die Ätzmaske nicht eingesetzt werden kann. Überraschenderweise hat sich jedoch gezeigt, daß das Plasmanitrid unter diese Bedingungen nicht abgetragen wird, so daß es als Maske zum Ätzen der Photoresistschicht 2 sehr geeignet ist. Eine Maske aus Siliciumnitrid mit einer Schichtdicke kleiner 0,1 µm hält ohne weiteres dem Ätzen der Photoresistschicht 2 in einer Dicke von 9 µm stand.

Beim Ätzen von Silicium mit $CF_4$ wird die Photoresistmaske wegen der Selektivität von Silicium zu 1350J-Photoresist von ungefähr 1 auch abgetragen. Wenn die Photoresistmaske hinreichend dick ist und vertikale Seitenwände aufweist, ist dies ohne Einfluß auf die Struktur, die in das Siliciumsubstrat geätzt wird. Wesentlich ist, daß die Fluorkonzentration in Plasma niedrig ist, denn dann ist es möglich, das Siliciumsubstrat gerichtet (anisotrop) zu ätzen. Bei der praktischen Durchführung des Verfahrens wurde pro 1 µm vertikale Ätzteife in Silicium ein laterales Ätzen von nur etwa 1/10 (~0,1 µm) beobachtet. Der "Ätzbias" ist dann etwa 1/10. Als Ergebnis werden Gräben in Silicium mit praktisch vertikalen Seitenwänden erhalten. Ein Muster in der dicken Photoresistmaske mit vertikalen Seitenwänden konnte mit Böschungswinkeln >89° in das Siliciumsubstrat übertragen werden.

Anhand der Fign. 2A—E wird noch eine Anwendung des erfindungsgemäßen Verfahrens zur Herstellung einer Maske beschrieben. Die Fig. 2 zeigt schematisch die Schritte zur Herstellung einer Maske für die Elektronenstrahl- oder Röntgenstrahllithographie. Als Maskensubstrat wird ein 0,2 bis 0,4 mm dicker Siliciumwafer mit einer 100-Orientierung, der auf beiden Seiten poliert ist, verwendet. Die Rückseite des Wafers (Fig. 2A) ist mit einer 0,5 bis 1 µm dicken Siliciumdioxidschicht 2 bedeckt. Von der Vorderseite des Siliciumwafers wird Bor in das Substrat eindiffundiert bis zu einer Oberflächenkonzentration von wenigstens $10^{20}$ Boratome/$cm^3$ (Schicht 3 in Fig. 2A). Die Bordiffusion dient also Ätzbarriere bei einem späteren Ätzen des Siliciumwafers und bestimmt dadurch die Maskenschichtdicke. Weiterhin bewirkt die Borkonzentration eine Zugspannung in der fertigen Maske, die ein Durchbiegen der Maske verhindert, wenn die Maske in ihrem starren kalten Siliciumrahmen erwärmt wird. Im nächsten Prozeßschritt (Fig. 2B) werden mehrere Fenster von Chipgröße auf der Rückseite durch konventionelle Photolithographie und Naßätzen hergestellt. Durch diese Fenster wird später das Ätzen des Wafers vorgenommen. Auf die Vorderseite des Wafers wird eine dicke Photoresistschicht 5 mit einer Schichtdicke bis zu 9 µm aufgetragen. Auf diese Resistschicht wird eine etwa 0,06 um dicke Siliciumnitridschicht 6 durch Plasmaabscheidung aufgetragen. Diese wiederum wird mit einer 0,2 µm dicken hochempfindlichen Resistschicht 7 bedeckt, in der das gewünschte Muster erzeugt wird. Die belichtete und entwickelte Photoresistschicht 7 dient als Maske für den Siliciumnitridätzprozeß, der mit folgenden Parameter durchgeführt wird:

| Gas: | $CF_4$ |
|---|---|
| Fluß: | 30 $cm^3$/Min. |
| Druck: | 66,5 µbar |
| Energiedichte: | 0,2 Watt/$cm^2$ |

Die strukturierte Siliciumnitridschicht 6 ist eine ausgezeichnete Maske für das reaktive Ionenätzen der dicken Resistschicht 5 in Sauerstoff und bewirkt gleichzeitig eine Verbesserung der Haftung des hochempfindlichen Resists 7 auf der Oberfläche.

In einem weiteren reaktiven Ionenätzschritt wird das Muster von der Siliciumnitridschicht 6 in die darunterliegende Photoresistschicht 5 übertragen. Das reaktive Ionenätzen wird mit folgenden Parameter durchgeführt:

| Gas: | $O_2$ |
|---|---|
| Fluß: | 27 $cm^3$/Min. |
| Druck: | 2,6 µbar |
| Energiedichte: | 0,2 Watt/$cm^2$ |
| Überätzung von 20%. | |

Die dicke Photoresistschicht 5 kann direkt als Maske für das reaktive Ionenätzen des Siliciums in einer $CF_4$ Atmosphäre verwendet werden. Weil der Photoresist gleich schnell oder sogar noch schneller als Silicium geätzt wird, muß die Resistmaske 5 in einer Schichtdicke von mindestens 7 bis 9 µm für das Ätzen eines Siliciumgrabens mit einer Tiefe von 4 µm hergestellt werden. Ein Vorteil des Dreilagenprozesses ist, daß mit ihm direkt die zum Ätzen verwendbare dicke Photoresistmaske hergestellt werden kann. Beim Ätzen mit dem weitaus aggressiveren System Chlor/Argon oder Helium/Argon sind weitere Prozeßschritte erforderlich, um eine Maske aus Siliciumdioxid herzustellen. Diese entfallen bei dem vorliegenden Verfahren.

Im folgenden Schritt (Fig. 2C) wird die strukturierte Photoresistschicht 5 verwendet, um ein Muster 8 von etwa 2 bis 4 µm Tiefe (Fig. 2D) in das bordotierte Silicium 3 zu ätzen.

Schließlich wird das Wafersubstrat durch die Öffnungen 4 in der Siliciumdioxidschicht 2 auf der Rückseite des Wafers in einem Naßätzprozeß gerichtet geätzt. Die Ätzlösung besteht aus Äthylendiamin, Brenzcatechin und Wasser. Das Ätzen hört auf bei einer Borkonzentration von $7 \times 10^{19}$ Boratomen/cm$^3$. Die resultierende Maske aus der einkristallinen, bordotierten Membran ist etwa 2 µm dick, in Abhängigkeit von der angewendeten Bordiffusion. Nach der Entfernung der restlichen Siliciumdioxidschichten 2 wird die strukturierte Siliciummembran mit einer 0,2 bis 0,8 µm dicken Goldschicht 9 belegt. Diese ist erforderlich, um einen Elektronenstrahl bis zu Energien von etwa 25 keV abzubremsen. Die Goldschicht kann entweder durch Aufdampfen oder Aufsputtern aufgebracht werden. Wenn Gold aufgesputtert wird, nehmen die Dimensionen der Maske geringfügig ab. Die fertige Maske ist in Fig. 2E dargestellt. Mit dem erfindungsgemäßen Verfahren, das die Herstellung einer dicken Photoresistmaske in einem Dreilagenprozeß und das reaktive Ionenätzen des Siliciumsubstrats mit CF$_4$ umfaßt, können Masken mit Linienbreiten bis hinab zu 0,3 µm hergestellt werden. Diese Masken können in einem Elektronenstrahldrucker verwendet werden, mit dem Muster dieser Dimensionen in einem Schattenwurfverfahren auf mit Photoresist beschichtete Wafer übertragen werden.

**Patentansprüche**

1. Verfahren zum Herstellen von Gräben mit im wesentlichen vertikalen Seitenwänden in Silicium, welches folgende Verfahrensschritte umfaßt:

A. Herstellen einer Maske, indem
a) 3 Schichten auf das Siliciumsubstrat (1) aufgebracht werden, wobei die auf dem Substrat (1) direkt aufgebrachte untere Schicht (2) aus einem Photoresist besteht und eine Schichtdicke im Bereich von 2 bis 9 µm aufweist; die nächste Schicht (3) aus Siliciumnitrid besteht und eine Schichtdicke im Bereich von 0,1 bis 0,2 µm aufweist und die oberste Schicht (4) aus einem hochempfindlichen Photoresist besteht und eine Schichtdicke im Bereich von 0,2 bis 0,5 µm aufweist;
b) das gewünschte Muster in der obersten Schicht (4) erzeugt wird und durch reaktives Ionenätzen mit CF$_4$ in die Schicht (3) aus Siliciumnitrid und mit Sauerstoff bei einem Druck unterhalb 4 µbar in die Schicht (2) aus Photoresist übertragen wird und

B. Reaktives Ionenätzen der Gräben (6) in das Siliciumsubstrat (1) durch die Öffnungen (5) der Maske in einem CF$_4$-Plasma, dessen Fluorkonzentration durch die Wahl eines CF$_4$-Flusses von ≤10 cm$^3$/Min. und die Anwendung einer fluorverbrauchenden Kathode sehr niedrig gehalten wird.

2. Verfahren nach Anspruch 1, dadurch gekennzeichnet, daß als untere Schicht (2) Photoresistmaterialien aus der Gruppe von Diazoketon sensibilisiertem Phenol- oder Kresol-Formaldehydharz, Polymethylmethacrylat, Polyisopren oder Polymermaterialien aus der Gruppe der Polyimide aufgetragen werden.

3. Verfahren nach Anspruch 1, dadurch gekennzeichnet, daß die Siliciumnitridschicht (3) durch Plasmaabscheidung aufgetragen wird.

4. Verfahren nach Anspruch 1, dadurch gekennzeichnet, daß die oberste Schicht (4) aus einem hochempfindlichen Resist auf der Basis von Diazoketon sensibilisiertem Phenol- oder Kresol-Formaldehydharz oder aus Polymethylmethacrylat besteht.

5. Verfahren nach einem oder mehreren der Ansprüche 1 bis 4, dadurch gekennzeichnet, daß das reaktive Ionenätzen der Schichten (3) und (2) und des Substrats (1) nacheinander in demselben Reaktor vorgenommen wird.

6. Verfahren nach den Ansprüchen 1, 3 und 5, dadurch gekennzeichnet, daß das Siliciumnitrid (3) in den freiliegenden Bereichen (5) der Maske (4) mit CF$_4$ bei einem Gasfluß von 30 cm$^3$/Min. einem Druck von 66,5 µbar und einer Energiedichte von 0,2 Watt/cm$^2$ geätzt wird.

7. Verfahren nach den Ansprüchen 1, 2 und 5, dadurch gekennzeichnet, daß die Photoresistschicht (2) in den freiliegenden Bereichen (5) der Maske 3 mit O$_2$ bei einem Gasfluß von 27 cm$^3$/Min. einem niedrigen Druck von ≤ 2,66 µbar une einer Energiedichte von 0,2 Watt/cm$^2$ geätzt wird.

8. Verfahren nach Anspruch 1, dadurch gekennzeichnet, daß die Gräben (6) in das Siliciumsubstrat (1) mit CF$_4$ bei einem Druck von 39,9 µbar und einer Energiedichte von 0,2 Watt/cm$^2$ geätzt werden.

9. Verfahren nach den Ansprüchen 1 und 8, dadurch gekennzeichnet, daß die Siliciumsubstrate (1) zum Ätzen der Gräben (6) auf eine Siliciumplatte gelegt werden, die auf der Kathode des Ionenätzreaktors aufliegt.

10. Anwendung eines der Verfahren nach den Ansprüchen 1 bis 9 zur Herstellung einer Elektronenstrahltransmissionsmaske (Fign. 2A—E), bei der Gräben (9) in eine bordotierte Siliciumschicht (3) auf einem Siliciumsubstrat (1) geätzt werden, das Siliciumsubstrat (1) von der Rückseite her durch eine Siliciumdioxidmaske (2) in einem anisotropen Ätzverfahren abgeätzt wird und die resultierende, strukturierte Membran (3) aus bordotiertem Silicium nach dem Entfernen der Siliciumdioxidschichten (2) mit einer Goldschicht (9) belegt werden.

**Revendications**

1. Procédé pour former des rainures à parois latérales essentiellement verticales dans du silicium, qui comprend les phases opératoires suivantes:

A. Fabrication d'un masque

a) en déposant 3 couches sur le substrat en silicium (1), auquel cas la couche inférieure (2) déposée directement sur le substrat (1) est constituée par une résine photosensible et possède une épaisseur de couche se situant dans la gamme comprise entre 2 et 9 μm; la couche immédiatement suivant (3) est constituée par du nitrure de silicium et possède une épaisseur située dans la gamme comprise entre 0,1 et 0,2 μm et la couche supérieure (4) est constituée par une résine photosensible de haute sensibilité et possède une épaisseur située dans la gamme comprise entre 0,2 et 0,5 μm;

b) en formant le modéle désiré dans la couche supérieure (4) et en le transférant, par corrosion ionique réactive avec du $CF_4$ dans la couche (3) en nitrure de silicium et avec de l'oxygéne sous une pression inférieure à 4 μbars dans la couche (2) constituée par la résine photosensible; et

B. Formation des rainures (6) par corrosion ionique réactive dans le substrat en silicium (1) à travers les ouvertures (5) des masques, dans un plasma de $CF_4$, dont la teneur en fluor est maintenue à une valeur très faible grâce au choix d'un débit de $CF_4 \leqslant 10$ cm³/mn et à l'utilisation d'une cathode consommant du fluor.

2. Procédé selon la revendication 1, caractérisé en ce que l'on dépose, comme couche inférieure (2), des matériaux formant des résines photosensibles et appartenant au groupe de la résine de phénol-formaldéhyde ou de crésol-formaldéhyde, sensibilisée par une diazocétone, du polyméthylméthacrylate, du polyisoprène ou des matériaux polyméres tirès du groupe des polyimides.

3. Procédé selon la revendication 1, caractérisé en ce que la couche de nitrure de silicium (3) est formée au moyen d'un dépôt plasmatique.

4. Procédé selon la revendication 1, caractérisé en ce que la couche supérieure (4) est constituée par une résine de haute sensibilité formée à base d'une résine de phénol-formaldéhyde ou de crésol-formaldéhyde sensibilisée par une diazocétone ou par du polyméthylméthacrylate.

5. Procédé selon une ou plusieurs des revendications 1 à 4, caractérisé en ce que la corrosion ionique réactive des couches (3) et (2) et du substrat (1) s'effectue successivement dans l'enceinte réactionnelle.

6. Procédé selon les revendications 1, 3 et 5, caractérisé en ce que le nitrure de silicium (3) est corrodé, dans les zones à nu (5) du masque (4) par du $CF_4$ avec un débit de gaz de 30 cm³/mn, une pression de 66,5 μbars et une densité d'énergie de 0,2 watt/cm².

7. Procédé selon la revendication 1, 2 et 5, caractérisé en ce que la couche de résine photosensible (2) est corrodée, dans les zones à nu (5) du masque (3), par du $O_2$ avec un débit de gaz de 27 cm³/mn, une basse pression ≤ 2,66 μbars et une densité d'énergie de 0,2 watt/cm².

8. Procédé selon la revendication 1, caractérisé en ce que les rainures (6) dans le substrat en silicium (1) sont corrodées au moyen de $CF_4$ sous une pression de 39,9 μbars et avec une densité d'énergie de 0,2 watt/cm².

9. Procédé selon les revendications 1 et 8, caractérisé en ce que pour l'aménagement des rainures (6) par corrosion, le substrat en silicium (1) est placé sur une plaque en silicium qui est disposée sur la cathode de l'enceinte réactionnelle de corrosion ionique.

10. Utilisation de l'un des procédés selon les revendications 1 à 9 pour fabriquer un masque de transmission d'un faisceau d'électrons (figure 2A—E), lors de laquelle on aménage des rainures (9) par corrosion dans une couche de silicium (3) dopée au bore, située sur un substrat en silicium (1), on élimine, au niveau de la face arrière, le substrat en silicium (1), moyennant l'utilisation d'un masque (2) de bioxyde de silicium, lors d'un procédé de corrosion anisotrope et on recouvre la membrane structurée résultant (3) formée par du silicium dopé par du bore, par une couche d'or (9), après élimination des couches (2) de bioxyde de silicium.

**Claims**

1. Method of making trenches with substantially vertical sidewalls in silicon, comprising the following process steps:

A. Making a mask in that

a) 3 layers are applied on the silicon substrate (1), the lower layer (2) applied on the substrate (1) directly consisting of a photoresist and having a thickness in the range of 2 to 9 μm; the next layer (3) consisting of silicon nitride and having a thickness in the range of 0.1 to 0.2 μm, and the top layer (4) consisting of a highly sensitive photoresist and having a thickness in the range of 0.2 to 0.5 μm;

b) that the desired pattern is generated in the top layer (4) and transferred into the silicon nitride layer (3) by reactive ion etching with $CF_4$ and with oxygen into photoresist layer (2) at a pressure of less than 4 μbar, and

B. Reactive ion etching of the trenches (6) into the silicon substrate (1) through the openings (5) of the mask in a $CF_4$ plasma whose fluorine concentration is kept very low by selecting a $CF_4$ flow of ≤ 10 cm³/min., and by using a fluorine-consuming cathode.

2. Method as claimed in claim 1, characterized in that as a lower layer (2) photoresist materials selected from the group consisting of diazoketone sensitized phenol or cresol formaldehyde resin, polymethylmethacrylate, polyisoprene or polymeric materials selected from the group of the poly-imides are applied.

3. Method as claimed in claim 1, characterized in that the silicon nitride layer (3) is applied by plasma deposition.

4. Method as claimed in claim 1, characterized in that the top layer (4) consists of a highly sensitive resist on the basis of diazoketone, sensitized phenol or cresol formaldehyde resin, or of polymethylmethacrylate.

5. Method as claimed in one or several of claims 1 to 4, characterized in that the reactive ion etching of the layers (3) and (2) and of the substrate (1) are effected successively in the same reactor.

6. Method as claimed in any one of claims 1, 3, and 5, characterized in that the silicon nitride (3) is etched in the exposed regions (5) of the mask (4) with $CF_4$ at a gas flow of 30 $m^3$/min., a pressure of 66.5 $\mu$bar, and an energy density of 0.2 Watt/$cm^2$.

7. Method as claimed in claims 1, 2 and 5, characterized in that the photoresist layer (2) in the exposed regions (5) of the mask (3) is etched with $O_2$, at a gas flow of 27 $cm^3$/min., a low pressure of $\leq$ 2.66 $\mu$bar, and an energy density of 0.2 Watt/$cm^2$.

8. Method as claimed in claim 1, characterized in that the trenches (6) are etched in a silicon substrate (1) with $CF_4$ at a low gas flow of $\leq$ 10 $m^3$/min., a pressure of 39.9 $\mu$bar, and an energy of 0.2 Watt/$cm^2$.

9. Method as claimed in claims 1 and 8, characterized in that for etching the trenches (6), the silicon substrates (1) are placed on a silicon plate arranged on the cathode of the ion etch reactor.

10. Using one of the methods as claimed in any one of claims 1 to 9 for making an electron beam transmission mask (Fig. 2A—E), where trenches (9) are etched in a boron-doped silicon layer (3) on a silicon substrate (1), where the silicon substrate (1) is etched off from the back through a silicon dioxide mask (2) in an anisotropic etching process, and where the resulting structured membrane (3) of boron-doped silicon is coated after the removal of the silicon dioxide layers (2) with a gold layer (9).

9

0 098 318

FIG. 1A

FIG. 1B

FIG.1C

FIG.1D

FIG.1E

FIG. 2 A

FIG. 2 B

FIG. 2 C

FIG. 2 D

FIG. 2 E

FIG.3